# EUROPEAN PATENT APPLICATION

(11) **EP 2 082 996 A1**
(43) Date of publication of application: **29.07.2009**
(21) Application number: 08001310.5
(22) Date of filing: 24.01.2008
(51) Int. Cl.: C03C 17/245, C23C 16/40, C23C 16/44

(54) **Improved method for depositing a metal-containing coating on a substrate**

(30) Priority: 22.01.2008 US 9822
(71) Applicant: Gulbrandsen Chemicals, Inc., Orangeburg SC 29115 (US)
(72) Inventor: Coney, Stuart, Snaith, East Yorkshire DN149RA (GB)
(74) Representative: Maiwald Patentanwalts GmbH

(57) **Abstract**

The present invention is in the field of methods for applying a protective coating onto a substrate, and more particularly, methods for applying a protective coating by application of a metal compound onto the hot glass surfaces using a chemical-vapor deposition (CVD) technique, the method comprising heating a liquid coating composition to a temperature of 200°C or more, vaporizing it and contacting the substrate having a temperature of 500°C or more.

## Description

### CROSS REFERENCE TO RELATED APPLICATIONS

This application is a continuation-in-part of United States Application No. 11/495,806 ("the '806 application"), filed on July 28, 2006, the disclosure of which is incorporated herein by reference.

### BACKGROUND OF THE INVENTION

The desirability of applying protective coatings to glass in general, and to the exterior of hollow glass containers in particular, has long been recognized. Such coatings, which include those resulting from the application of tin, titanium or other heat-decomposable inorganic and organic metal compounds, have been disclosed to protect the glass surface from damage such as from abrasion and scratches which can be unsightly and may cause a loss of tensile strength. The need for high tensile strength in, for example, glass containers is particularly acute when the containers are mass-produced, moved rapidly in close proximity along high-speed conveyors, and are subsequently filled with beverages, foodstuffs, and the like, particularly those which are carbonated or can produce gaseous pressure within the container.

Protective coatings are often applied to glass articles, such as flat glass, glass containers and the like, when they emerge from a forming machine in a heated, fully-shaped condition, that is, at the "hot" end of the glass making process. The containers are thereafter transported from the forming machine to a coating area, also known as a "hood," by a conveyor. Temperatures, often in excess of 600°C, exist at the surface of the glass containers so that when a heat decomposable metal containing compound is applied to those surfaces, the compound decomposes and/or otherwise converts to a protective coating, e.g., a metallic-oxide film coating.

In many of the hot-end coating hoods used today, a liquid coating composition containing a heat-decomposable inorganic and/or organic metal compound is pumped as a liquid into the hood where it may or may not fully vaporize. Other times, a vapor is created before entry into the hood. In either event, for some liquid coating compositions to properly vaporize and function in a hot-end coating hood temperature of the hood and/or the temperature of the vaporizing liquid the should be in the 120°C to 140°C range.

Many of the coating systems generally available today rely solely on the heat from the bottles passing through the hood to raise the air temperature of the hood to operating temperature for coating. This heated air may also be used to heat the coating composition. If the temperature is not high enough, such as during start-up, when that heat is applied to the coating material, the coating material may not vaporize completely. For some of the coating compositions, including those of the present invention, this may also lead to the premature vaporization of some components of the coating composition while other components remain in liquid form, which may possibly cause a separation of the coating composition thereby reducing stability, efficacy, and the like of the overall process. Some hoods offer optional internal heating systems of various designs to more quickly bring the entire hood to the preferred operating temperature thus reducing the amount of improperly coated glass bottles. However, this heating process requires significant electrical demand and temperature is still influenced by passive heat from the bottles.

Therefore, there is still a great need to develop a simple, economical and more efficient coating process in applying a protective coating onto a substrate using the CVD technique. Further, there is a great need to develop a process which allows liquid coating composition of the present invention to enter the hood in a vaporized state or form a vapor therein so that a greater efficiency will be achieved during the operation of the system.

### SUMMARY OF THE INVENTION

Applicants have discovered that raising the air temperature of the hood to the 120°C to 140°C range by relying on the heat from the bottles passing through the hood, or even using heaters in the hood are at best inefficient and sometimes ineffective in heating liquid coating compositions, particularly those of the present invention, for application onto a substrate. In fact, applying the liquid coating composition of the present invention in the conventional systems described herein sometimes plugged the liquid coating lines in the system with a thick viscous material, requiring frequent shutting down of the production line for maintenance and cleaning of the system.

Applicants have also discovered that some liquid coating compositions, including those of the present invention, are preferably heated to and/or vaporized at much higher temperatures than the 120°C to 140°C range so often used currently. In fact, when the liquid coating composition is comprised of more than one component, and especially where large quantities of water are involved, it is preferable to heat the liquid coating composition to about 200°C or more, preferably about 250°C or more, more preferably about 250°C to about 450°C, even more preferably between about 250°C to 350°C, and most preferably at about 300°C and vaporizing the liquid coating composition. Without being bound by any particular theory, it is believed that by elevating the temperature of liquid coating compositions to such higher temperatures prior to or during vaporization, all of the components of the liquid coating composition will be vaporized simultaneously. Vaporizing at temperatures lower than 200°C may cause certain components to vaporize prior to others, creating undesirable separation with some components. It is believed that this may be the reason for the buildup of residue in the hood, feed lines, or other parts of the apparatus.

Moreover, running a hood at elevated temperatures, either passively or by heaters used in the hood, as a means of heating a liquid coating composition is disadvantageous because more of the coating forms on the internal components of the hood causing maintenance and other issues. And, it has long been the goal of glass plants to run the hood at the lowest possible temperature to prevent such build up but still allow for the vaporization of the liquid coating composition. These goals are often competing.

Generally, the present invention relates to methods for applying a protective coating onto a substrate, and more particularly, methods for applying a protective coating by applying a metal containing organic compound onto the hot glass surfaces using a chemical-vapor deposition (CVD) technique.

More specifically, in one embodiment, the present invention relates to a method for applying a protective coating onto a substrate comprising heating a liquid coating composition to a temperature of about 200°C or more, preferably about 250°C or more, more preferably about 250°C to about 450°C, even more preferably between about 250°C to 350°C, and most preferably at about 300°C and vaporizing the liquid coating composition; contacting a substrate having a temperature at or above 500°C with the vapor so as to provide a coating on at least a portion of the substrate. The present invention contemplates all configurations which allow heating of the liquid coating composition to about 200°C or more and vaporizing the liquid coating composition prior to its contact with the substrate in the hood. The location of the means to actively control the temperature of the liquid coating composition, and indeed the point at which the liquid is heated and vaporized, does not matter so long as the liquid coating composition is heated and vaporized and remains in its vaporized state prior to its contact with the substrate. In some embodiments, it may be desirable to vaporize near the hood to reduce reaction of the vapor with the coating apparatus. The heated liquid coating composition may be vaporized in the hood, or it may be vaporized prior to introduction into the hood. The resulting vapor, in some embodiments, is not as hot as the heated liquid coating composition. Indeed, the vapor may be at about 120°C to about 140°C when it contacts the substrate.

In another preferred embodiment, the coating composition used is an organic metal compound which can be tin or other metals as described herein. In one preferred embodiment, the coating composition used (a) about 10 weight % to about 90 weight % of organic metal compound, (b)about 5 weight % to about 50 weight % of water, and (c) about 5 weight % to about 45 weight % of a lower alkyl alcohol. In particularly preferred embodiment, the metal compound is tin.

In another preferred embodiment, the coating composition used (a) about 25 weight % to about 75 weight % of organic metal compound, (b) about 15 weight % to about 40 weight % of water, and (c) about 10 weight % to about 35 weight % of a lower alkyl alcohol. In particularly preferred embodiment, the metal compound is tin.

In another embodiment, the present invention relates to a method for applying a protective coating onto a surface of a substrate comprising heating a liquid coating composition to a temperature of about 200°C or more, preferably about 250°C or more, more preferably about 250°C to about 450°C, even more preferably between about 250°C to 350°C, and most preferably at about 300°C using, inter alia, recycled hot air from a hood and an external heater/evaporator; vaporizing the coating composition; and contacting a substrate having a temperature at or above 500°C with the vapor of the coating composition so as to provide a coating on at least a portion of the substrate; wherein the liquid coating composition comprises (a) about 10 weight % to about 90 weight % of organic metal compound, (b) about 5 weight % to about 50 weight % of water, and (c) about 5 weight % to about 45 weight % of a lower alkyl alcohol. The additional heating necessary to elevate the temperature of the liquid coating composition above the temperature of the ambient air in the hood can be supplied by a heater or an evaporator equipped with a heater.

In another preferred embodiment, the organic metal compound can be tin or other metals as described herein. The present invention contemplates all configurations which allow the temperature of the liquid coating composition to be heated and/or actively controlled to a level significantly above that of the hood (e.g., 50°C or more). The location of the means to actively control the temperature of the liquid coating composition, and its point of vaporization, may vary so long as the coating composition is heated and vaporized and remains in its vaporized state prior to the its contact with the substrate. In some embodiments, it may be desirable to vaporize in or near the hood to reduce further reaction of the vapor.

In accordance with some aspects of the invention, the method of applying a protective coating has an improved efficiency compared to a prior art process using prior art coating solutions. The liquid coating compositions described above and the coated substrates made using same are also contemplated.

The present invention is a significant advance. It allows for the use of the CVD methods, yet, it is insensitive to and indeed benefits from the presence of moisture in the surrounding atmosphere and in particular, in the formation itself. For example, (1) it allows for a deposit of the liquid coating composition on the glass substrate regardless of hood temperature, which is especially important in that it allows the first bottles through the hood to be coated without the hood having to be heated to vaporize the liquid coating composition;

(2) it allows for the hood to be run cooler reducing the build up of material on the interior of the hood, which in turn allows for longer run times between cleaning of the hood, reduces downtime for maintenance, and lowers cost;

(3) it allows for proper vaporization of the liquid coating composition of the present invention, reducing the incidence or severity of viscous materials plugging the lines of the system, requiring frequent shut-down of the system;

(4) it will reduce environmental emissions of hazardous decomposition products; and

(5) it consumes less energy than conventional heating processes in that it only heats, for instance, the liquid coating composition and not the entire hood.

### BRIEF DESCRIPTION OF THE DRAWINGS

A more complete appreciation of the subject matter of the present invention and the various advantages thereof can be realized by reference to the following detailed description in which reference is made to the accompanying drawings in which:

Figure 1 is a flow diagram of a bottle-coating process according to an embodiment of the present invention.

Figure 2 is a flow diagram of a bottle-coating process according to another embodiment of the present invention.

Figure 3 is a flow diagram of a bottle-coating process according to yet another embodiment of the present invention.

Figure 4 is a flow diagram of a bottle-coating process according to still another embodiment of the present invention.

### DETAILED DESCRIPTION

Throughout the entire specification, including the claims, the word "comprise" and variations of the word, such as "comprising" and "comprises," as well as "have," "having," "includes," "include" and "including," and variations thereof, means that not only the named steps, elements or materials to which it refers, form a construct within the scope of the claim or disclosure but also other steps, elements or materials which may be added still form a construct within the scope of the claim or disclosure. When recited in describing the invention and in a claim, it means that the invention and what is claimed is considered to what follows and potentially more. These terms, particularly when applied to claims, are inclusive or open-ended and do not exclude additional, unrecited elements or methods steps. The term "between" as used in connection with a range includes the endpoints unless the context suggests otherwise. All references to testing are at room temperature (20-25°C) unless otherwise specified and all references to temperature are in degrees Celsius unless otherwise specified.

In describing the preferred embodiments of the present invention, specific terminology will be resorted to for the sake of clarity. However, the invention is not intended to be limited to the specific terms so selected, and is understood that each specific term includes all technical equivalence which operate in a similar manner to accomplish the same purpose.

The term "alkyl" used herein includes a straight chain, branched, or cyclic group comprised of carbon and hydrogen having 1 to 24 carbon atoms. These may be substituted with halogens, hydroxyl groups, sulfur or nitrogen containing group, esters, ethers, and the like. The term "lower alkyl" used herein includes any alkyl group explained above having 1 to 6 carbon atoms.

The term "organic metal compound(s)" or "organic metal containing compound(s)" used herein includes a compound that contains both an organic group and a metal. The organic group includes a collection of atoms comprised essentially of carbon and hydrogen, however, other elements, such as nitrogen, sulfur, silicon or oxygen, may also be present. These organic groups include, without limitation, hydrocarbons (such as alkanes, alkenes, alkynes, dienes, arenes), alkyl halides, alkenyl halides, aryl halides, alcohols, phenols, epoxides, aldehydes, ketone, carboxylic acids, acyl halids, acid anhydrides, esters, amides, amines, nitriles, nitro compounds., thiols, and sulfides. Of these, alkyl halides are preferred. The metal includes metals belonging to groups 3, 4, 5, and 6 of the Periodic tables. These include Ti, Si, B, Ta, Nb, Zr, Sn, Sr, Al, In or a mixture thereof. The most preferred metal compounds contain Sn and Ti, and, thus, the term "organic metal compound(s)" used herein preferably includes "organic tin compound(s)" and "organic titanium compound(s)." The organic metal compounds used herein may also include salt formers and/or counter ions. The term "organic metal compound(s)" or "organic metal containing compound(s)" does not include inorganic metal compounds.

By "heating the liquid coating composition to 200°C or more and vaporizing" or words to that effect, it is meant that vaporization occurs either because of the higher temperatures caused by the use of a heating source or the use of an evaporator or both. Vaporization may begin during heating or may occur after heating the liquid coating composition.

The term "substrate" used herein includes glass such as glass containers, flat glass, ceramics, plastics, metals, and mixtures thereof.

The term "overall efficiency" used herein is defined as the ratio between the amount of elemental metal deposited to the substrate and the amount of elemental metal introduced for the purpose of coating. For example, in a typical prior art coating process for glass bottles, it is expected that about 4 kg of MBTC are required to deposit 37 c.t.u. (coating thickness unit, or CTU) of metal oxide film onto 209,000 glass bottles (20 Oz.). The amount of elemental metal (i.e., tin) present in 4 kg of MBTC is 1.65 kg. At 37 c.t.u., the amount of elemental metal (i.e., tin) actually deposited on the glass bottles is calculated to be 0.47 kg. Therefore, the overall efficiency of a typical prior art coating process is 0.47 kg/1.65 kg (the amount of elemental metal deposited/the amount of elemental metal introduced), which is about 28% overall efficiency. It is noted that while a fixed number of bottles is specified in calculating efficiency, actual overall efficiency is dependent on the particular process conditions. Regardless, the present invention is expected to show an improvement for any given set of conditions. By using the present invention including the step of heating the liquid coating compositions to higher temperatures prior to or during vaporization, overall efficiency can be achieved over an extended period of time.

In a preferred embodiment, the methods and compositions of the present invention are used in a so-called "hot-end coating" for substrates in general and glass containers in particular. The hot end of a glass making process is where the molten glass is formed into a container in a forming machine. In a forming machine, a stream of molten glass at its plastic temperature (1050°C to 1200°C) is cut by shearing blade to form a cylinder of glass. Then the glass is eventually blown into the mold to make the final container shape. The forming process, occurring over a short period of time (6-20 seconds), leaves the container with internal stresses which then need to be relieved through annealing. An annealing oven (known in the industry as a *Lehr*) first heats the container up to 580°C then cools it, depending on the glass thickness, over a 20-60 minute period.

Applying protective coatings to the exterior of glass containers are accomplished in a so-called "hood" after the containers emerge from the forming machine and before entering the annealing Lehr. Of course, they can be applied in an analogous place in other processes. Hoods, which isolate the glass containers from some ambient conditions, are well known and widely used for applying a protective coating to hot glass containers. Coating hoods substantially representative of the prior art are disclosed in U.S. Patent Nos. 3,819,404, 3,933,457, 4,389,234 and 5,140,940.

The hood generally has at least one feed point to introduce the liquid coating composition of the present invention as a liquid or in its vaporized state, and blowers to move the vapors of the liquid coating composition across the containers to form a film on the surface of the hot glass containers. The hood also includes an exhaust system which captures most of the air-entrained coating compound not adhering to, for example, the glass containers.

One embodiment of the present invention is a bottle-coating apparatus that employs a heat source external to the hood for actively elevating and/or controlling the temperature of a liquid coating composition. In some embodiments, the external heat source is housed within an evaporator. In others, these are both external, but not necessarily disposed together. The term "evaporator" is meant to encompass all types of chambers where a liquid coating composition may be heated, mixed, stored, and/or undergo transformation of its properties. The heating element may be used independently from the evaporator in the apparatus. Regardless of the configuration of the apparatus, the liquid coating composition must be heated to a temperature of about 200°C or more, and vaporized prior to contact with the substrate(s) in the hood. The configuration of the apparatus can take on many forms.

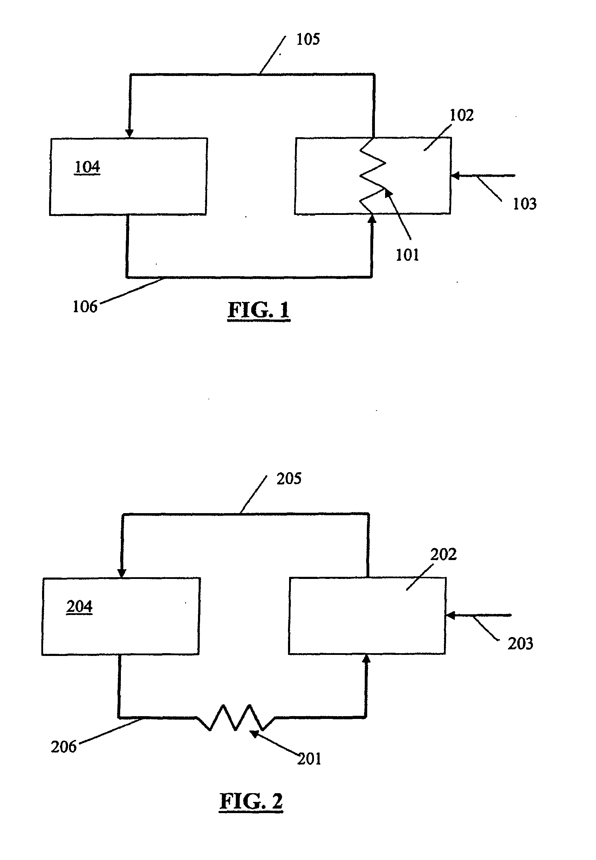

For instance, FIG. 1 shows a first exemplary embodiment wherein a heating element 101 is disposed within an evaporator 102. A liquid coating composition is introduced into evaporator 102 through an entrance line 103, where the liquid coating composition is actively heated to a certain temperature and the heated composition is fed into a hood 104 through a feed line 105. The temperature at which the composition is heated allows all of the components of the liquid coating composition to simultaneously vaporize before entering hood 104. Evaporator 102, equipped with heating element 101, is preferably disposed substantially close to the connection between feed line 105 and hood 104. Recycled air from hood 104 reenters evaporator 102 through a recycled air line 106 where it may be used to aid in the heating of the liquid coating composition.

FIG. 2 depicts a second exemplary embodiment wherein a heating element 201 is disposed in a recycled air line 206 through which a hood 204 feeds recycled air back into an evaporator 202. Heating element 201 actively heats the liquid coating composition via the recycled air to a desired temperature where it travels to evaporator 202, wherein it enters hood 204 in a vaporized state. Recycled air leaving hood 204 will travel through recycled air line 206 to evaporator 202 and may be heated by heating element 201. This recycled air will provide heat to the liquid coating composition which enters evaporator 202 through entrance line 203 and the combination of composition and recycled air will be fed back into hood 204 through a feed line 205. The temperature of the recycled air may be such that in mixing with composition it will increase the temperature of the mixture to a point which will allow vaporization of the composition when it enters hood 204. Evaporator 202 may further alter one or more properties of the mixture to aid in raising its temperature.

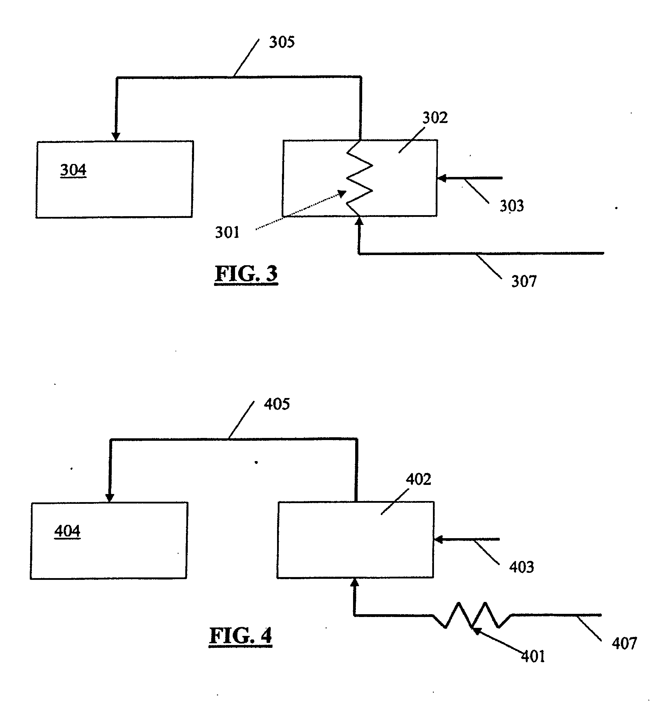

A third exemplary embodiment is depicted in FIG. 3 that does not use recycled air. Rather, liquid coating composition is added to an evaporator 302 which contains a heating element 301. Heating element 301 may then actively raise the temperature of the composition, the components of which are vaporized nearly simultaneously, and the composition may enter into a hood 304 in a vaporized state. Hood 304 may have an exit line where excess composition is either saved for later use or disposed of. The saved composition may be separately added to the evaporator a later time if such is desired.

FIG. 4 depicts a fourth exemplary embodiment that also does not use recycled air. Liquid coating composition is added to an evaporator 402 which also allows introduction of air through an external line 407 where the air is heated by a heating element 401 placed upstream from evaporator 402. The heated air then raises the temperature of the composition to a desired temperature which is subsequently fed into a hood 404 in a vaporized state. This embodiment is similar to that of FIG. 2 in that the composition will be heated by air that is previously heated by heating element 401. As in the embodiment in FIG. 3, the excess composition in the hood may be either saved or disposed of.

In all of the above systems, as well as in any other contemplated, the present invention contemplates all configurations which allow the temperature of the liquid coating composition to be heated and/or actively controlled, and consistent with the non-binding theory of operation, preferably to a point where all components of the liquid coating composition is are in a vaporization state prior to the contact with the substrate in the hood. The location of the means to actively control the temperature of the liquid coating composition, and indeed the point at which the liquid coating composition is vaporized, does not matter so long as all of the components the liquid coating composition are vaporized simultaneously, and the liquid coating composition remains in its vaporized state prior to its contact with the substrate. In some embodiments, it may be desirable to vaporize near the hood to reduce further reaction of the vapor.

There may also be multiple feed lines and/or external heating elements so that different materials can be independently heated to their respective vapor states and subsequently introduced into the hood. The vaporized materials can be combined prior to introduction into the hood, or they may be directed so that they combine after entry into the hood.

Additional variations of the system depicted in FIGS. 1-4 may be used which employ a heating element external to the hood. The present invention contemplates all configurations which allow the temperature of the liquid coating composition to be actively controlled, and preferably to a point where the liquid is in its vaporization state prior to its introduction into the hood. For example, where hot liquid introduced into the hood vaporizes upon the release of pressure from entering the hood, no separate evaporator may be necessary. This does not mean, however, that the liquid coating composition is in the form of a vapor prior to being introduced into the hood. That is not important. What is important is that a vapor is formed prior to contact with the substrate and that the liquid is heated to a sufficient temperature.

In each of the embodiments discussed above, a heating element is employed which heats and/or actively controls the temperature of the liquid coating composition. This presents an advantage over existing systems which may only passively use heat from the bottles passing through the hood to aid in raising the temperature of the liquid coating composition prior to its introduction into the hood.

This active control/maintenance of the liquid coating composition at a higher temperature has many advantages. First, it allows for the hood to be run at a cooler temperature. A lower operating temperature of the hood thus reduces the operating temperature of the plant or facility in which the apparatus is used. Less energy is required to run the apparatus because the entire volume of the hood does not need to be maintained at a high temperature for the process to be operated effectively. Further, the energy required to run the heating element is considerably less than that required to heat the hood. Second, heating the liquid coating composition at higher temperatures is believed to prevent the separation of the coating compositions, reducing the undesirable buildup of residue in the hood, feed lines, or other parts of the apparatus. This, of course, reduces the frequency at which the hood and other parts of the apparatus must be cleaned, reducing the downtime of the apparatus. Along these lines, the connection of the feed lines to the hood, namely the entrance and exit holes, will not require maintenance as often to clean or unclog them.

The preferred hood used in accordance with the present invention is the Gulbrandsen GE series of coating system(s), manufactured by Gulbrandsen Chemicals Inc., the hood being fitted with an electrically heated external evaporator. Gulbrandsen will have available a retrofit for existing manufacturer's hoods which will provide somewhat similar efficiency results, but not necessarily all of the same benefits and features, as those on the GE series hood. However, comparable results should be obtainable from other systems including most of those in current usage by the glass container industry. While the foregoing was described in the context of glass containers, it generally applies equally well to other substrates and, in particular, sheet flat glass.

A temperature sensing mechanism may be used in conjunction with the external heat source. This mechanism would allow the user to monitor the temperature of the liquid coating composition, the surface temperature of the evaporator, the temperature of the feed line which contains the heated liquid coating composition, or the temperature of a line containing hot air which will be used to heat the liquid coating composition. Once the apparatus has run through enough cycles so that the temperature inside the hood has risen, the increase in hood temperature may aid in keeping the temperature of the recycled liquid coating composition at a level where the heating element can be used to a lesser degree, more sparingly, or not at all. The temperature sensing mechanism can aid in determining whether the temperature of the liquid coating composition is greater or less than necessary, so that the use of the heating element can be adjusted accordingly. The temperature sensing mechanism may also sense that the operating temperature of the liquid coating composition is greater than necessary and cause the apparatus to slow or shut down. Temperature sensing mechanisms, include thermostats, thermocouples, and the like.

Any liquid coating composition which may be heated and/or vaporized at the operating temperatures described herein may be used. However, in particular, the liquid coating composition of the present invention is in the form of liquid at the room temperature, which may be vaporized and applied in a hood as described or in some other manner. The vaporized form of the liquid coating composition of the present invention is generally formed by pumping or otherwise moving the liquid coating composition into a chamber or conduit where it contacts a heating element at a temperature of about 200°C or more, preferably about 250°C or more, more preferably about 250°C to about 450°C, even more preferably between about 250°C to 350°C, and most preferably at about 300°C. Such high temperatures are preferable because it is believed, without limitation, that a liquid coating composition comprised of more than one component will vaporize simultaneously and uniformly rather than by vaporizing as individual components. When a coating composition vaporizes as individual components, the composition becomes altered with certain components separating in their liquid states. Such separate liquid components may create undesirable buildup of residue in the hood, feed lines, or other parts of the apparatus. Further, these higher temperatures may be higher than the vaporization point of the coating composition as a whole. Because there could, in some embodiments, be at least some distance between the point of vaporization and the point of contact between the coating composition and the substrate(s), the temperature of the vaporized composition may cool while it travels to the substrate(s) while maintaining the vaporized state. This vapor is subsequently directed at the substrate to be coated and the temperature could be as low as 120°C.

It is an alternate embodiment of the invention to add the vaporized coating composition to the hood at a temperature greater than the ambient temperature in the hood, preferably by at least about 50°C, preferably about 100°C.

This vapor is applied to the glass containers in the hood as explained above to provide a protective coating onto the containers. At that point, the containers are preferably at about or above the decomposition temperature of the organic metal compound used in the coating composition. Generally, the temperature of the containers is at least about 500°C, preferably at least about 600°C.

In another embodiment of the present invention, the substrate (e.g., glass container) can be a preexisting and preformed container that was previously produced, cooled, and even used. An already manufactured container can be heated to a temperature as disclosed herein and a liquid coating composition of the present invention applied as a vapor.

Unlike the teaching of the prior art references that many inorganic tin and organic tin compounds are extremely vulnerable to moisture causing inefficiency of the method, the inventors of the present invention surprisingly discovered a highly efficient liquid coating composition which is formulated with water, indeed about 5 to about 50 weight % of water. In fact, it has been discovered that having about 5 to about 50 weight % of water in a liquid coating composition not only unexpectedly improved the overall efficiency of the CVD coating process, but also allowed the process to be relatively insensitive to the presence of moisture in the surrounding atmosphere as well. These formulations, despite the high water content, are also storage stable at room temperature. By "storage stable," it is meant that the prepared compositions of the present invention are able to be stored at room temperature for at least 3 months, more preferably about 6 months, and even more preferably at least about one year without substantial deterioration so that it can still be used as a coating composition. Employing water in a solvent system allows the coating process of the present invention to be simple and economical compared to the prior art processes.

Other additives may be put into the mixture at any time (i.e., during, before or after the organic metal compound is introduced) to the mixture, providing they do not cause an adverse reaction so that the liquid coating composition deteriorates and cannot be used as a coating composition.

In a preferred embodiment, the liquid coating composition of the present invention comprises (a) about 10 to about 90 weight % of an organic metal compound, (b) about 5 to about 50 weight % of water, and (c) about 5 to about 45 weight % of an alkyl alcohol relative to the total liquid coating composition. Preferably, the liquid coating composition of the present invention comprises (a) about 20 to about 80 weight % of an organic metal compound, (b) about 10 to about 45 weight % of water, and (c) about 10 to about 40 weight % of an alkyl alcohol relative to the total weight of the liquid coating composition. More preferably, the liquid coating composition of the present invention comprises (a) about 30 to about 65 weight % of an organic metal compound, (b) about 15 to about 35 weight % of water, and (c) about 15 to about 35 weight % of an alkyl alcohol relative to the total weight of the liquid coating composition.

In yet another preferred embodiment, the liquid coating composition of the present invention comprises (a) about 10 to about 90 weight % of an organic tin compound, (b) about 5 to about 50 weight % of water, and (c) about 5 to about 45 weight % of a lower alkyl alcohol relative to the total liquid coating composition. Preferably, the liquid coating composition of the present invention comprises (a) about 25 to about 75 weight % of an organic tin compound, (b) about 15 to about 40 weight % of water, and (c) about 10 to about 35 weight % of a lower alkyl alcohol relative to the total weight of the liquid coating composition. More preferably, the liquid coating composition of the present invention comprises (a) about 40 to about 60 weight % of an organic tin compound, (b) about 20 to about 30 weight % of water, and (c) about 15 to about 30 weight % of a lower alkyl alcohol relative to the total weight of the liquid coating composition. The foregoing is based on MBTC as the organic tin compound. These weights will vary with the weights of other tin compounds used. However, they should provide the same range of elemental tin regardless of which organic tin-containing compound is used.

In yet another preferred embodiment, the liquid coating composition of the present invention consists essentially of (a) about 10 to about 90 weight % of an organic metal compound, (b) about 5 to about 50 weight % of water, and (c) about 5 to about 45 weight % of an alkyl alcohol relative to the total liquid coating composition. Preferably, the liquid coating composition of the present invention consists essentially of (a) about 20 to about 80 weight % of an organic metal compound, (b) about 10 to about 45 weight % of water, and (c) about 10 to about 40 weight % of an alkyl alcohol relative to the total weight of the liquid coating composition. More preferably, the liquid coating composition of the present invention consists essentially of (a) about 30 to about 65 weight % of an organic metal compound, (b) about 15 to about 35 weight % of water, and (c) about 15 to about 35 weight % of an alkyl alcohol relative to the total weight of the liquid coating composition.

In yet another preferred embodiment, the liquid coating composition of the present invention consists essentially of (a) about 10 to about 90 weight % of an organic tin compound, (b) about 5 to about 50 weight % of water, and (c) about 5 to about 45 weight % of a lower alkyl alcohol relative to the total liquid coating composition. Preferably, the liquid coating composition of the present invention consists essentially of (a) about 25 to about 75 weight % of an organic tin compound, (b) about 15 to about 40 weight % of water, and (c) about 10 to about 35 weight % of a lower alkyl alcohol relative to the total weight of the liquid coating composition. More preferably, the liquid coating composition of the present invention consists essentially of (a) about 40 to about 60 weight % of an organic tin compound, (b) about 20 to about 30 weight % of water, and (c) about 15 to about 30 weight % of a lower alkyl alcohol relative to the total weight of the liquid coating composition. The foregoing is based on MBTC as the organic tin compound. These weights will vary with the weights of other tin compounds used. However, they should provide the same range of elemental tin regardless of which organic tin-containing compound is used.

In another preferred embodiment, the liquid coating composition of the present invention further comprises about 1 x 10⁻⁸ to about 20 weight % of an additive, preferably about 1 x 10⁻⁶ to about 5 weight % relative to the total weight of the liquid coating composition.

Examples of the organic metal compound which can be used in accordance with the present invention include, but are not limited to, organic tin compounds and organic titanium compounds.

Non-limiting examples of organic tin compounds which can used in accordance with the present invention include, but are not limited to, an alkyltin trichloride, dialkyltin dichloride, an alkyldichlorotin acetate, an alkylchlorotin diacetate, monobutyltin trichloride, isobutyltin trichloride, methyltin trichloride, dibutyltin dichloride, diisobutyltin dichloride, di-t-butyltin dichloride, butyldichlorotin acetate, butylchlorotin diacetate, carbethoxyethyltin trichloride, and a mixture thereof. Of these, MBTC is the preferred organic tin compound.

Non-limiting examples of organic titanium compounds which can be used in accordance with the present invention include, but are not limited to, tetra (C1-C18) alkoxy titanate, methyl triethoxy titanium (iv), methyl titanium (iv) triisopropoxide, methyl titanium (iv) tributoxide, methyl titanium (iv) tri-t-butoxide, isopropyl titanium (iv) tributoxide, butyl titanium (iv) triethoxide, butyl titanium (iv) tributoxide, phenyl titanium (iv) triisopropoxide, phenyl titanium (iv) tributoxide, phenyl titanium (iv) triisobutoxide, and a mixture thereof.

Non-limiting examples of water which can be used in accordance with the present invention include, but are not limited to, tap water, filtered water, distilled water, deionized water and a mixture thereof. Of these, distilled and deionized water are preferred.

Non-limiting examples of lower alkyl alcohols which can be used in accordance with the present invention include, but are not limited to, methanol, ethanol, isopropanol, pentanol, n-propanol, t-butanol and a mixture thereof. Of these, methanol and ethanol are preferred.

Non-limiting examples of additives which can be used in accordance with the present invention include, but are not limited to, a coloring agent, an UV absorber, an UV inhibitor a pigment, a dye, a photochromic compound, and a mixture thereof. Of these, a coloring agent is the preferred additive.

The liquid coating composition of the present invention can be manufactured on-site by mixing various ingredients mentioned above, or can be prepackaged and sold in containers of various sizes and quantities. The liquid coating compositions of the present invention are preferably stable at room temperature for at least about 3 months, more preferably about 6 months, and even more preferably at least about one year.

The liquid coating composition of the present invention facilitates a highly efficient coating process for depositing a protective coating, such as metal oxide film, onto the substrates. Accordingly, the liquid coating composition of the present invention will provide an increase in efficiency over that obtained under the same conditions, using the same equipments and facility using any prior art protective coating solution based on either inorganic or organic tin compounds. The new liquid coating composition of the present invention will provide an increase in efficiency over that obtained under the same conditions, regardless of bottle size and speed. Specifically, the present invention significantly increase the overall efficiency of the coating process by at least about 10% compared to the prior art processes using prior art coating solutions. It is expected that different performance efficiencies will be seen of both products at different bottle speeds and process conditions, but that the percentage difference between the regular product and the new formulation should remain somewhat similar.

This amounts to a considerable cost savings to the industry since a much lower amount of the expensive organic metal compounds is wasted during the coating process. By using a lower amount of organic metal compounds and by producing less amount of organic metal compound waste, the present invention also will enhance the quality of the environment.

A CTU is a well known measure of the thickness of the coating by the American Glass Research Institute of Butler, Pa. One CTU unit is approximately equal to 2.2 Angstrom units. One Angstrom unit is equal to 10⁻⁸ cm. When a glass container is determined to have a coating thickness of, for example, 35 c.t.u., it is understood by one of ordinary skill in the art that the coating thickness on the main body of the glass container will provide good scratch and damage resistance to the glass surface after the cold end coating is applied.

In a preferred embodiment, the thickness of the protective coating formed by contacting a vapor of the liquid coating composition of the present invention onto a hot surface of a substrate is from about 10 c.t.u. to about 100 c.t.u., preferably from about 30 c.t.u. to about 50 c.t.u.

The following examples illustrate the subject matter of the invention in further details.

EXAMPLE 1

Glass Bottles (20 Oz.) coming out the continuous forming process were contacted for about between 18 and about 21 hours with vapors of various liquid coating compositions as shown below including a commercial prior art MBTC coating material as a control example. The liquid coating compositions of the present invention (Samples 2 and 3) were produced by forming an alcohol-water solution first, then adding MBTC to the solution.

| Material | MBTC (wt %) | Water (wt %) | Methanol (wt %) | Total (wt %) |
|---|---|---|---|---|
| Sample 1: commercial MBTC coating material (G-Coat-H110) | 98 | <50 p.p.m. | 2 | 100 |
| Sample 2: liquid coating composition of the present invention containing high MBTC content | 62.5 | 20.2 | 17.3 | 100 |
| Sample 3: liquid coating composition of the present invention containing low MBTC content | 44.4 | 30.0 | 25.6 | 100 |

The results of these experiments are summarized in tabular form as follows:

| | Overall Efficiency (%) | Coating Thickness (c.t.u.) | Temperature of vaporized coating material (°C) | Substrate Temperature (°C) |
|---|---|---|---|---|
| Sample 1 | 22.9 | 37.2 | 200 | 650 |
| Sample 2 | 26.2 | 40.5 | 200 | 650 |
| Sample 3 | 37.2 | 42.5 | 200 | 650 |

- Sample 2, which is the liquid coating composition of the present invention containing high MBTC content, increased the overall efficiency of the coating process by about 14%.
- Sample 3, which is the liquid coating composition of the present invention containing low MBTC content, increased the overall efficiency of the coating process by about 62%.

These results were obtained using a bottle forming machine operating speed overtime at 145 b.p.m. The amount of tin on bottle was calculated using publicly available information on deposited material per c.t.u. per unit area, area of bottles made and chemical weights. The information is provided in a paper by F. Geotti- Bianchini et al., Evaluation of tin oxide coatings on glass containers using HECM and EPMA, Glass Technology, vol. 35. No. 5 (Oct. 1994). The equipment used to run Example 1 is tabulated below:

| Resource | Description |
|---|---|
| Bottle making equipment | 8IS section double gob - ran at 145 b.p.m. |
| Hot End Coating equipment | Arkema C3-42" long |
| Bottle | Amber 20 oz beer-coated area 367.6 cm² |

EXAMPLE 2

Glass jars (250 ml) coming out of the continuous forming machine were contacted with vapors for about 4 hours with various liquid coating compositions as shown below including a commercial prior art MBTC coating material as a control sample. The liquid coating composition of the present invention (Sample 5) was produced by forming an alcohol-water solution first, then adding MBTC to the solution.

| Material | MBTC (wt %) | Water (wt %) | Methanol (wt %) | Total (wt %) |
|---|---|---|---|---|
| Sample 4: commercial MBTC coating material (G-Coat-H110) | 98 | <50 p.p.m. | 2 | 100 |
| Sample 5: liquid coating composition of the present invention containing medium MBTC content | 58.9 | 22.2 | 18.9 | 100 |

The results of these experiments are summarized in tabular form as follows:

| | Overall Efficiency (%) | Coating Thickness (c.t.u.) | Temperature of vaporized coating material (°C) | Substrate Temperature (°C) |
|---|---|---|---|---|
| Sample 4 | 44.7 | 31.7 | 150 | 650 |
| Sample 5 | 74.8 | 39.7 | 150 | 650 |

- Sample 5, which is the liquid coating composition of the present invention containing medium MBTC content, increased the overall efficiency of the coating process by about 68%.

These results were obtained using a bottle forming machine operating speed overtime at 150 b.p.m. The amount of tin on bottle was calculated using publicly available information on deposited material per c.t.u. per unit area, area of bottles made and chemical weights. The information is provided in a paper by F. Geotti- Bianchini et al., Evaluation of tin oxide coatings on glass containers using HECM and EPMA, Glass Technology, vol. 35. No. 5 (Oct. 1994).

The equipment used to run Example 1 is tabulated below:

| Resource | Description |
|---|---|
| Bottle making equipment | 8IS section double gob - ran at 150 b.p.m. |
| Hot End Coating equipment | Vidromecânica VSQR - 1200 mm long |
| Bottle | Flint 250 ml jar - coated area 179.5 cm² |

EXAMPLE 3

The liquid coating compositions of the following formulations were also tested. The results showed an improvement in the overall efficiency of the coating process by at least about 10% compared to a prior art MBTC coating process.

| No. | MBTC (weight %) | Methanol (weight %) | Water (weight %) | Total |
|---|---|---|---|---|
| Sample 6 | 53 | 15 | 17 | 100 |
| Sample 7 | 50 | 16 | 19 | 100 |
| Sample 8 | 47 | 17 | 20 | 100 |
| Sample 9 | 45 | 18 | 22 | 100 |
| Sample 10 | 42 | 19 | 23 | 100 |
| Sample 11 | 38 | 22 | 25 | 100 |

EXAMPLE 4

Further, the liquid coating compositions of the following formulations were tested using an evaporator equipped with a heater. The trial for sample 12 ran for about 22 hours. Upon completion of the trial, the lines were checked and confirmed that there was no residue buildup.

| Material | MBTC (wt %) | Water (wt %) | Methanol (wt %) | Total (wt %) |
|---|---|---|---|---|
| Sample 12: liquid coating composition of the present invention containing low MBTC content | 44.4 | 30 | 25.6 | 100 |

The results of these experiments are summarized in tabular form as follows:

| | Overall Efficiency (%) | Coating Thickness (c.t.u.) | Temperature of evaporator surface (°C) | Substrate Temperature (°C) |
|---|---|---|---|---|
| Sample 12 | 57.3 | 54 | 300 | 650 |

The equipment used to run Example 4 is tabulated below:

| Resource | Description |
|---|---|
| Bottle making equipment | 8IS section double gob - ran at 85 b.p.m. |
| Hot End Coating equipment | Arkema C3-42" long fitted with Gulbrandsen External Evaporator with a heater |
| Bottle | Amber whiskey-coated area +/- 580 cm² |

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the spirit and scope of the present invention as defined by the appended claims.

## Claims

1. A method for applying a protective coating onto a substrate comprising:
heating a liquid coating composition to a temperature of about 200°C or more and vaporizing the liquid coating composition;
contacting a substrate having a temperature at or above 500°C with the vapor so as to provide a coating on at least a portion of the substrate.

2. The method of claim 1, wherein the liquid coating composition comprises
(a) about 10 weight % to about 90 weight % of organic metal compound,
(b) about 5 weight % to about 50 weight % of water, and
(c) about 5 weight % to about 45 weight % of a lower alkyl alcohol.

3. The method of claim 2, wherein the organic metal compound is an organic tin compound.

4. The method of claim 3, wherein the organic tin compound is monobutyltin trichloride.

5. The method of claim 2, wherein the water is tap, filtered, distilled, deionized water or a mixture thereof.

6. The method of claim 2, wherein the lower alkyl alcohol is ethanol, methanol or a mixture thereof.

7. The method of claim 1, wherein the substrate is a glass.

8. The method of claim 7, wherein the glass is a glass container or a flat glass.

9. The method of claim 1, wherein the liquid coating composition is heated to a temperature of about 250°C or more.

10. The method of claim 9, wherein the liquid coating composition is heated to a temperature between about 250°C and about 450°C.

11. The method of claim 10, wherein the liquid coating composition is heated to a temperature between about 250°C and about 350°C.

12. The method of claim 11, wherein the liquid coating composition is heated to a temperature of about 300°C.

13. The method of claim 1, wherein the step of contacting the substrate with the vapor is performed in a hood.

14. The method of claim 13, wherein the temperature of the heated liquid coating composition is at least about 50°C greater than the ambient temperature in the hood.

15. The method of claim 1, wherein the step of heating the liquid coating composition is performed using recycled air from a hood and an evaporator equipped with a heating element.

16. The method of claim 1, wherein the step of heating the liquid coating composition is performed using recycled air from a hood and a heating element.

17. The method of claim 1, further comprising a step of actively controlling the temperature of the liquid coating composition at about 200°C or more and vaporizing the liquid coating composition prior to contacting the substrate.

18. The method of claim 1, wherein the step of contacting the substrate with the vapor provides an improved overall efficiency.

19. The method of claim 2, wherein the liquid coating composition comprises
(a) about 25 weight % to about 75 weight % of organic metal compound,
(b) about 15 weight % to about 40 weight % of water, and
(c) about 10 weight % to about 35 weight % of a lower alkyl alcohol.
